# EUROPEAN PATENT SPECIFICATION

(11) **EP 3 623 867 B1**
(45) Date of publication and mention of the grant of the patent: **14.08.2024**
(21) Application number: 19193091.6
(22) Date of filing: 22.08.2019
(51) Int. Cl.: G03F 7/038, G03F 7/039, G03F 7/075, G03F 7/09, G03F 7/40, G03F 7/42, H01L 21/033, H01L 21/308

(54) **PATTERNING PROCESS**
STRUKTURIERUNGSVERFAHREN
PROCESSUS DE FORMATION DE MOTIFS

(30) Priority: 13.09.2018 JP 2018171333
(43) Date of publication of application: 18.03.2020
(73) Proprietor: Shin-Etsu Chemical Co., Ltd., Tokyo 100-0005 (JP)
(72) Inventor: Ogihara, Tsutomu, Niigata (JP); Yano, Toshiharu, Niigata (JP); Maeda, Kazunori, Niigata (JP); Mitsui, Ryo, Niigata (JP); Nagata, Takeshi, Niigata (JP)
(74) Representative: Wibbelmann, Jobst

(56) References cited:
- EP-A1- 3 508 918
- US-A1- 2005 277 756
- US-A1- 2006 281 266
- US-A1- 2009 163 030
- US-A1- 2013 034 963
- US-A1- 2018 158 674
- MEISSNER D ET AL: "Optical absorption of amorphous hydrogenated carbon thin films", THIN SOLID FILMS, ELSEVIER, AMSTERDAM, NL, vol. 283, no. 1, 1 September 1996 (1996-09-01), pages 196 - 203, XP004053665, ISSN: 0040-6090, DOI: 10.1016/0040-6090(95)08251-4

## Description

### TECHNICAL FIELD

The present invention relates to a patterning process by a sidewall spacer method as defined in the claims.

### BACKGROUND ART

In photo-exposure widely employed in 1980s, a g-beam (436 nm) or an i-beam (365 nm) of a mercury lamp had been utilized as a light source of exposure light used in the resist patterning. As a means for further miniaturization, shifting to exposure light having shorter wavelength was considered effective. Hence, for the mass production processes of DRAM (Dynamic Random Access Memory) with 64 M bits (work size of 0.25 µm or less) in 1990s and later ones, a KrF excimer laser having a shorter wavelength (248 nm) has been utilized in place of the i-beam (365 nm) as the exposure light source.

However, for production of DRAMs with integration of 256 M and 1 G or more which require further finer processing technologies (work size of 0.2 µm or less), a light source having a shorter wavelength is necessary. Thus, a photolithography using an ArF excimer laser (193 nm) has been investigated seriously over a decade. At first, it was expected that the ArF lithography would be applied to the fabrication of 180 nm-node devices. However, the KrF excimer lithography was continuously employed until the mass production of 130 nm-node devices. The full-fledged application of the ArF lithography started from the 90 nm-node. Further, the mass production of 65 nm-node devices is now underway by combining the ArF lithography with a lens having an increased numerical aperture (NA) of 0.9. In pursuit of further shortening of the exposure light wavelength for the next 45 nm-node devices, F₂ lithography with 157 nm wavelength became a candidate. Nevertheless, there are many problems in the F₂ lithography: increased cost for a scanner due to use of large quantities of expensive CaF₂ single crystal for a projection lens; extremely poor durability of a soft pellicle, which leads to change of an optical system due to introduction of a hard pellicle; decrease in etching resistance of a resist film, and so forth. Because of these problems, development of the F₂ lithography was suspended, and the ArF immersion lithography was introduced.

In the ArF immersion lithography, water having a refractive index of 1.44 is introduced between a projection lens and a wafer by a partial fill method, thereby enabling high speed scanning. Thus, mass production of the 45 nm-node devices is now underway by using a lens with a NA of 1.3.

For the 32 nm-node lithography technology, lithography with a vacuum extreme-ultraviolet beam (EUV) of 13.5 nm wavelength is considered as a candidate. Problems of the EUV lithography include a higher output power of the laser, a higher sensitivity of the resist film, a higher resolution, a lower line edge roughness (LER), a non-defect MoSi laminate mask, a lower aberration of the reflective mirror, and so forth. Hence, there are innumerable problems to be solved. Development of the immersion lithography with a high refractive index, which is another candidate for the 32 nm-node, was suspended because the transmittance of LUAG, a candidate for a high-refractive-index lens, is low and because the refractive index of the liquid could not reach an aimed value of 1.8. Accordingly, in the photo exposure used as a general technology, the resolution based on the wavelength of a light source is approaching to its inherent limit.

Hence, recently, a double patterning process has drawn an attention as one miniaturization technology, in which a pattern is formed by a first photo-exposure and development; then, a pattern is formed by a second photo-exposure exactly in the space of the first pattern (Non Patent Document 1). Many processes have been proposed as double patterning methods. For example, there is a method (1) in which a photo resist pattern with a line-and-space interval of 1:3 is formed by a first photo-exposure and development; an underlying hard mask is processed by dry etching; another hard mask is formed thereon; in the space portion formed by the first photo-exposure, a line pattern is formed by photo-exposure and development for a photo resist film; and then, the hard mask is dry-etched to form a line-and-space pattern having a half width of the first pattern pitch. There is also another method (2) in which a photo resist pattern with a space-and-line interval of 1:3 is formed by a first photo-exposure and development; an underlying hard mask is processed by dry etching, and coated with a photo resist film; the remaining part of the hard mask is subjected to photo-exposure for a second space pattern; and then, the hard mask is dry-etched. In both of these methods, the hard mask is processed twice by dry etching.

In the former method, the hard mask needs to be formed twice. In the latter method, one layer of the hard mask is enough, but a trench pattern needs to be formed in which resolution is more difficult to achieve than a line pattern. Moreover, in the latter method, a negative resist material may be used to form the trench pattern. In this method, high-contrast light may be used as in a case of forming a line using a positive development pattern. However, a negative resist material has a lower dissolution contrast than a positive resist material. Thus, in comparison between a case of forming a line with a positive resist material and a case of forming a trench pattern of the same dimension with a negative resist material, the use of a negative resist material results in a lower resolution. In the latter method, a thermal flow method is applicable in which a wide trench pattern is formed using a positive resist material, and the trench pattern is then shrunk by heating the substrate; alternatively, a RELACS method is applicable in which a trench pattern after development is coated with a water-soluble film, and the trench is shrunk by heating and crosslinking of the resist film surface. These methods however have disadvantages of deterioration of a proximity bias and a low throughput due to the further complicated process.

In both of the former and latter methods, the substrate needs to be etched twice. This causes problems of lower throughput as well as pattern deformation and misalignment by the two etchings.

To perform the etching only once, there is a method in which a negative resist material is used in the first photo-exposure and a positive resist material is used in the second photo-exposure. There is another method in which a positive resist material is used in the first photo-exposure, and a negative resist material dissolved in a higher alcohol that has 4 or more carbon atoms but does not dissolve the positive resist material is used in the second photo-exposure. In these methods, . the resolution is lowered due to the use of the negative resist material having a low resolution.

As another method, a method has been proposed in which patterns formed by a first photo-exposure and development are treated with a reactive metal compound to insolubilize the patterns; then, second patterns are newly formed between the first patterns by photo-exposure and development (Patent Document 1).

The most critical problem in such double patterning is the overlay accuracy of the first and the second patterns. Variation of the line dimensions depends on the magnitude of the position displacement. Thus, for example, to form 32-nm lines with 10% accuracy, the overlay accuracy within 3.2 nm is necessary. Because the overlay accuracy of a current scanner is about 8 nm, a substantial improvement in the accuracy is necessary.

Because of the overlay accuracy problem of a scanner and the difficulty to divide one pattern into two, a method is investigated by which a pitch is halved in a single photo-exposure. For example, a sidewall spacer method has been proposed in which a pitch is halved by forming films on both sides of a line pattern sidewall (Non Patent Document 2). As this sidewall spacer method, there have been proposed: a spacer space method in which a hard mask of a resist underlayer and a film embedded in a space between films attached on sidewalls of the hard mask are used as an etching pattern; and a spacer line method in which films attached on hard mask sidewalls of a resist underlayer are used as an etching pattern (Non Patent Document 3).

As the sidewall spacer method, another method has been proposed in which sidewalls of SiO₂, α-Si, α-C, or the like are formed to a core pattern by a CVD method, and then the core pattern is removed by dry etching, thereby forming the sidewall pattern, so that the pattern pitch is halved. However, in this case, the heating temperature of 150°C or higher is necessary to form the sidewalls. Accordingly, when the resist pattern formed by photo-exposure is used as the core, the pattern is collapsed at such a high temperature; thus, the core strength is insufficient for the spacer. Hence, the smoothness of the formed pattern is poor in comparison with the original resist pattern. US 2013/0034963 A1 discloses methods of forming fine patterns for a semiconductor device including forming a hard mask layer on an etch target layer; forming a carbon containing layer on the hard mask layer; forming carbon containing layer patterns by etching the carbon containing layer; forming spacers covering opposing side walls of each of the carbon containing layer patterns; removing the carbon containing layer patterns; forming hard mask patterns by etching the hard mask layer using the spacers as a first etching mask; and etching the etch target layer by using the hard mask patterns a second etching mask. US 2006/0281266 A1 discloses variations in the pitch of features formed using pitch multiplication that are minimized by separately forming at least two sets of spacers. US 2009/0163030 A1 discloses a first silicon containing film, an organic material film, a second silicon containing film are formed, wherein the second silicon containing film is patterned to have a narrow width pattern and a wide width pattern, wherein the organic material film is patterned to have a narrow width pattern and a wide width pattern, wherein a side wall is formed on a side surface of the second silicon containing film and the organic material film by coating with a third silicon containing film, wherein the narrow width pattern of the second silicon containing film is removed by using a mask that covers the second silicon containing film patterned to have a wide width pattern and the side wall, wherein the organic material film is finally removed. US 2018/0158674 A1 discloses aromatic resin polymers and compositions containing them that are useful as underlayers in semiconductor manufacturing processes. The article "Optical absorption of amorphous hydrogenated carbon thin films" by Helmbold et al. (published in Thin Solid Films, 283 (1996) 196-203) discloses amorphous hydrogenated carbon layers that were deposited from ethylene in a capacitively coupled r.f.-discharge reactor under different self-bias voltages and by addition of different amounts of phosphine as an assumed "doping" gas.

### CITATION LIST

### PATENT LITERATURE

Patent Document 1: Japanese Unexamined Patent Application Publication No. 2008-33174

### NON PATENT LITERATURE

Non Patent Document 1: Proc. SPIE, Vol. 5754, p. 1508 (2005)
Non Patent Document 2: J. Vac. Sci. Technol., B17 (6), Nov/Dec 1999
Non Patent Document 3: Fourth Symposium on Liquid Immersion (2007), Presentation No.: PR-01, Title: Implementation of immersion lithography to NAND/CMOS device manufacturing

US 2013/0034963 A1
US 2006/0281266 A1
US 2009/0163030 A1
US 2018/0158674 A1
"Optical absorption of amorphous hydrogenated carbon thin films" by Helmbold et al. (Thin Solid Films, 283 (1996) 196-203)

### SUMMARY OF INVENTION

### TECHNICAL PROBLEM

Accordingly, the resulting resist pattern is not directly utilized as a core pattern. Instead, a core material made of SiO₂ or α-C is used, and the resist pattern is transferred to this core material by dry etching. Then, sidewalls are formed to the core material having the transferred pattern. Subsequently, the core material is removed, so that a pattern having a halved pattern pitch can be formed. In this event, since the core material made of SiO₂ or α-C is formed by CVD or ALD, the strength is quite high and the core material has favorable properties. However, after the sidewall formation, when the unnecessary core material is removed by dry etching, the high strength hinders a sufficient etching selectivity ratio relative to a substrate. The substrate is damaged in the dry etching step for removing the core material. These result in problems of insufficient product performance and yield decrease.

As has been described above, to cope with the recent miniaturization of pattern rule, a patterning process capable of easily and efficiently forming a finer pattern, and also a smoother pattern has been demanded.

An object of the present invention is to improve the above-described situations and to provide a patterning process capable of solving the problems of poor product performance and yield decrease.

### SOLUTION TO PROBLEM

To achieve the object, the present invention provides a patterning process comprising the steps of:
(1) forming on a substrate an organic underlayer film, a silicon-containing middle layer film thereon, and further an upper layer resist film thereon;
(2) subjecting the upper layer resist film to exposure and development to form an upper layer resist pattern;
(3) transferring the upper layer resist pattern to the silicon-containing middle layer film by dry etching using the upper layer resist film having the formed upper layer resist pattern as a mask, and further transferring the upper layer resist pattern to the organic underlayer film by dry etching using the silicon-containing middle layer film having the transferred upper layer resist pattern as a mask to form an organic underlayer film pattern;
(4) forming an inorganic silicon film by a CVD method or an ALD method so as to cover the organic underlayer film pattern;
(5) removing a portion of the inorganic silicon film by dry etching to expose an upper portion of the organic underlayer film pattern; and
(6) removing the organic underlayer film pattern with a stripping liquid to form an inorganic silicon film pattern whose pattern pitch is 1/2 of that of the upper layer resist pattern,

wherein the silicon-containing middle layer film is formed from a composition for forming a silicon middle layer, the composition containing a compound having a crosslinking organic structure,
the organic underlayer film contains any of a fluorene skeleton-containing compound, a carbazole skeleton-containing compound, an acenaphthylene skeleton-containing compound, a naphthol skeleton-containing compound, and a bisnaphthol skeleton-containing compound, and
the inorganic silicon film is made of polysilicon, amorphous silicon, silicon oxide, silicon oxynitride, silicon carbide, or a composite material thereof.

According to such a patterning process, the organic underlayer film can be removed simultaneously with the silicon middle layer, which might remain after the dry etching, by washing with the stripping liquid that does not damage the inorganic silicon film constituting sidewalls and the substrate. This makes it possible to form the inorganic silicon film pattern (sidewall pattern) whose pattern pitch is 1/2 of that of the upper layer resist pattern without damaging the sidewalls and the substrate.

The inorganic silicon film is made of polysilicon, amorphous silicon, silicon oxide, silicon nitride, silicon oxynitride, silicon carbide, or a composite material thereof.

The inorganic silicon film in the present invention can be ones as described above.

In addition, in the step (1), a water-repellent coating film may be further formed on the upper layer resist film.

When the upper layer resist pattern is formed, if the upper layer resist needs a top coat to employ immersion exposure, the patterning process as described above is adoptable.

Further, in the step (3), the organic underlayer film pattern may have the silicon-containing middle layer film remaining on the organic underlayer film.

Alternatively, in the step (3), the organic underlayer film pattern may not have the silicon-containing middle layer film remaining on the organic underlayer film.

In the inventive patterning process, even when the material having served as a mask remains or does not remain after the pattern is transferred by the dry etching, the inorganic silicon film pattern (sidewall pattern) can be formed without damaging the sidewalls and the substrate.

Further, in the step (6), the stripping liquid preferably contains one or both of hydrogen peroxide and sulfuric acid.

Such a stripping liquid is capable of more surely removing the organic underlayer film pattern by washing without damaging the inorganic silicon film constituting sidewalls and the substrate to thus form the inorganic silicon film pattern (sidewall pattern).

The silicon-containing middle layer film is formed from a composition for forming a silicon middle layer, the composition containing a compound having a crosslinking organic structure.

Such a silicon-containing middle layer film can be more surely removed simultaneously with the organic underlayer film by the washing with the stripping liquid after the dry etching.

In this event, the crosslinking organic structure is preferably one or more selected from an oxirane ring, an oxetane ring, a hydroxyl group, or a carboxyl group.

Such a crosslinking organic structure makes the silicon-containing middle layer film further surely removable simultaneously with the organic underlayer film by the washing with the stripping liquid after the dry etching.

Preferably, the composition for forming a silicon middle layer further contains an acid generator which generates an acid by one or both of heat and light.

Preferably, the composition for forming a silicon middle layer further contains a crosslinking agent.

Such a composition(s) for forming a silicon middle layer promote crosslinking of the oxirane ring, oxetane ring, hydroxyl group, carboxyl group, or the like contained as the crosslinking organic structure. In addition, the composition is capable of forming a silicon-containing middle layer film that is surely removable by washing simultaneously with the organic underlayer film even after the dry etching.

### ADVANTAGEOUS EFFECTS OF INVENTION

The present invention enables patterning with excellent smoothness without causing the problems of poor product performance and yield decrease because the use of the organic underlayer film as a core material in the sidewall spacer process allows the stripping liquid to remove the core material by washing without damaging the substrate after the dry etching. Therefore, the present invention makes it possible to provide a highly practical patterning process which is capable of easily and efficiently forming a finer pattern and is applicable to semiconductor manufacturing processes.

### BRIEF DESCRIPTION OF DRAWINGS

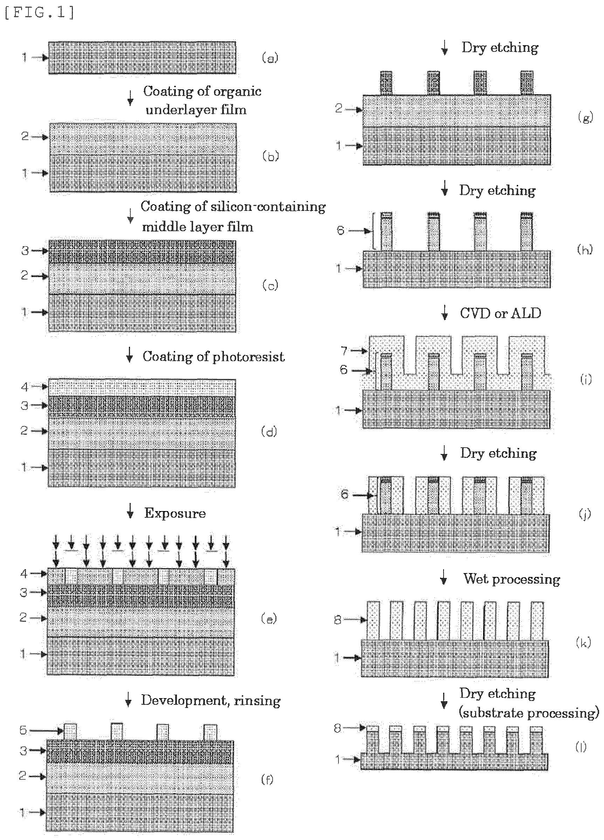

FIG. 1 shows explanatory drawings of one example of a patterning process according to the present invention.

### DESCRIPTION OF EMBODIMENTS

As described above, as the recent pattern rule progresses toward further miniaturization, there have been increased needs for a highly practical patterning process capable of easily and efficiently forming a finer pattern and applicable to semiconductor manufacturing processes.

To achieve the above object, the present inventors have earnestly studied and consequently found that when a resist pattern formed by photo-exposure and development is transferred to an organic underlayer film and then sidewalls are formed by CVD or ALD on this organic underlayer film having the transferred pattern, the organic underlayer film serving as a core material can be easily removed with a stripping liquid without damaging the substrate. This finding has led to the completion of the present invention.

Specifically, the present invention is a patterning process comprising the steps of:
(1) forming on a substrate an organic underlayer film, a silicon-containing middle layer film thereon, and further an upper layer resist film thereon;
(2) subjecting the upper layer resist film to exposure and development to form an upper layer resist pattern;
(3) transferring the upper layer resist pattern to the silicon-containing middle layer film by dry etching using the upper layer resist film having the formed upper layer resist pattern as a mask, and further transferring the upper layer resist pattern to the organic underlayer film by dry etching using the silicon-containing middle layer film having the transferred upper layer resist pattern as a mask to form an organic underlayer film pattern;
(4) forming an inorganic silicon film by a CVD method or an ALD method so as to cover the organic underlayer film pattern;
(5) removing a portion of the inorganic silicon film by dry etching to expose an upper portion of the organic underlayer film pattern; and
(6) removing the organic underlayer film pattern with a stripping liquid to form an inorganic silicon film pattern whose pattern pitch is 1/2 of that of the upper layer resist pattern.

Hereinafter, the present invention will be described in detail. However, the present invention is limited to the scope of the claims, only.

An embodiment of the present invention will be described with reference to the drawing, but the present invention is limited to the scope of the claims, only. FIG. 1 shows explanatory drawings for illustrating one example of the patterning process according to the present invention. First, in the step (1), an organic underlayer film (coating-type organic underlayer film) 2 is formed on a substrate (substrate to be processed) 1. A silicon-containing middle layer film (silicon-containing, coating-type middle layer film) 3 is formed on the organic underlayer film 2. Further, an upper layer resist film 4 is formed on the silicon-containing middle layer film 3 (FIG. 1(a), (b), (c), (d)). Next, in the step (2), the upper layer resist film 4 is subjected to photo-exposure (FIG. 1(e)), development, and rinsing to obtain an upper layer resist pattern 5 (FIG. 1(f)). Next, in the step (3), the upper layer resist pattern 5 is transferred to the silicon-containing middle layer film 3 by dry etching using the pattern as a mask (FIG. 1(g)). Further, the pattern formed in the silicon-containing middle layer film is transferred to the organic underlayer film 2 using the pattern as a mask. Thereby, an organic underlayer film pattern 6 is formed (FIG. 1(h)). In this event, to make the organic underlayer film pattern have rectangular cross sections, the dry etching conditions are commonly set such that the silicon-containing middle layer film 3 remains on an upper portion of the organic underlayer film pattern 6. Nevertheless, the silicon-containing middle layer film 3 does not always have to be left in this way in the present invention. In the step (4), the organic underlayer film pattern 6 obtained in the step (3) is then covered with an inorganic silicon film 7 by a CVD method or an ALD method (FIG. 1(i)). Subsequently, in the step (5), the inorganic silicon film 7 is etched by dry etching to expose the upper portion of the organic underlayer film pattern 6 (FIG. 1(j)). In this event, in the case where the silicon-containing middle layer film 3 remains on the upper portion of the organic underlayer film pattern 6, what is actually exposed as the upper portion of the organic underlayer film pattern 6 is the silicon-containing middle layer film 3 which remains after the dry etching step. Thereafter, in the step (6), a silicon-containing middle layer film residue and the organic underlayer film pattern 6 remaining as a core within the inorganic silicon film 7 are simultaneously removed by washing with a stripping liquid, so that an inorganic silicon film pattern 8 can be formed whose pitch is 1/2 of a pitch of the upper layer resist pattern 5 (FIG. 1(k)). After that, the substrate can be processed using the obtained inorganic silicon film pattern 8 (FIG. 1(l)).

Hereinafter, each step will be sequentially described in detail.

### [Step (1)]

The step (1) is a step of forming on a substrate an organic underlayer film, a silicon-containing middle layer film thereon, and further an upper layer resist film thereon.

### <Substrate>

As the substrate, it is possible to use, for example, a substrate for manufacturing a semiconductor, the substrate having any of a metal film, a metal carbide film, a metal oxide film, a metal nitride film, and a composite of these films formed thereon as a layer to be processed (portion to be processed).

As the substrate for manufacturing a semiconductor, a silicon substrate is generally used, but the substrate is not particularly limited thereto. A material different from that of the layer to be processed may be used such as Si, amorphous silicon (α-Si), p-Si, SiO₂, SiN, SiON, W, TiN, and Al.

As the metal constituting the layer to be processed, it is possible to use any of silicon, titanium, tungsten, hafnium, zirconium, chromium, germanium, copper, aluminum, and iron, or an alloy thereof. As the layer to be processed containing such a metal, used are, for example, Si, SiO₂, SiN, SiON, SiOC, p-Si, α-Si, TiN, WSi, BPSG, SOG, Cr, CrO, CrON, MoSi, W, W-Si, Al, Cu, Al-Si, and the like; various low dielectric films, and etching stopper films thereof. The layer can be formed to have a thickness of normally 50 to 10,000 nm, particularly 100 to 5,000 nm.

### <Organic underlayer film>

The organic underlayer film (coating-type organic underlayer film) used in the present invention is defined in the claims. Many resins constituting the organic underlayer film are known. In the present invention, the organic underlayer film contains any of a fluorene skeleton-containing compound, a carbazole skeleton-containing compound, an acenaphthylene skeleton-containing compound, a naphthol skeleton-containing compound, and a bisnaphthol skeleton-containing compound

Examples of the bisnaphthol compound include resins as follows, which are described in Japanese Unexamined Patent Application Publication Nos. 2007-199653, 2010-122656, and so forth.

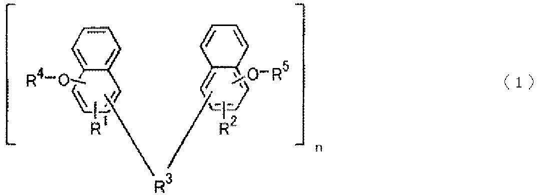

In the above formula, R¹ and R² are the same or different and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond, or an alkylene group having a linear, branched, or cyclic structure with 1 to 30 carbon atoms, and optionally has a bridged cyclic hydrocarbon group, a double bond, a hetero atom, or an aromatic group having 6 to 30 carbon atoms; R⁴ and R⁵ each independently represent a hydrogen atom or a glycidyl group; and "n" represents an integer of 1 to 4. 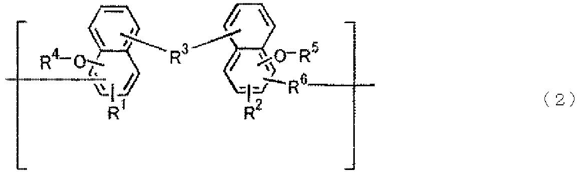 In the above formula, R¹ and R² are the same or different and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond, or an alkylene group having a linear, branched, or cyclic structure with 1 to 30 carbon atoms, and optionally has a bridged cyclic hydrocarbon group, a double bond, a hetero atom, or an aromatic group having 6 to 30 carbon atoms; R⁴ and R⁵ each independently represent a hydrogen atom or a glycidyl group; and R⁶ represents a single bond or a linear or branched alkylene group having 1 to 10 carbon atoms.

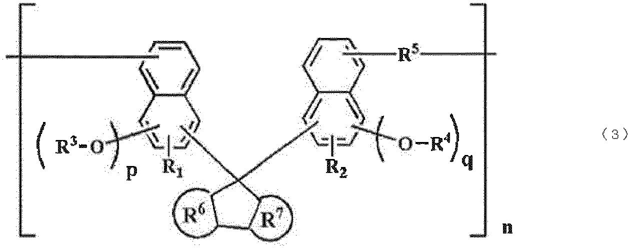

In the above formula, R¹ and R² are the same or different and each represent a hydrogen atom, a linear, branched, or cyclic alkyl group having 1 to 10 carbon atoms, an aryl group having 6 to 10 carbon atoms, or an alkenyl group having 2 to 10 carbon atoms; R³ and R⁴ each represent a hydrogen atom or a glycidyl group; R⁵ represents a single bond or a linear or branched alkylene group having 1 to 10 carbon atoms; R⁶ and R⁷ each represent a benzene ring or a naphthalene ring; "p" and "q" each represent 1 or 2; and "n" represents 0<n≤1.

An example of the fluorene compound includes a resin as follows, which is described in Japanese Unexamined Patent Application Publication No. 2008-274250 and so forth.

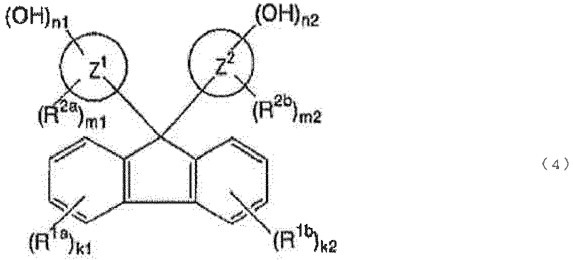

In the formula, the ring Z¹ and the ring Z² each represent a condensed polycyclic aromatic hydrocarbon ring; R^{1a}, R^{1b}, R^{2a}, and R^{2b} represent the same or different substituents; k1 and k2 are the same or different and each represent an integer of 0 or 1 to 4; m1 and m2 each represent an integer of 0 or 1 or more; and n1 and n2 each represent an integer of 0 or 1 or more, given that n1+n2≥1.

Examples of the naphthalene compound include resins as follows, which are described in Japanese Unexamined Patent Application Publication Nos. 2004-264710, 2005-043471, 2005-250434, 2007-293294, 2008-65303, and so forth.

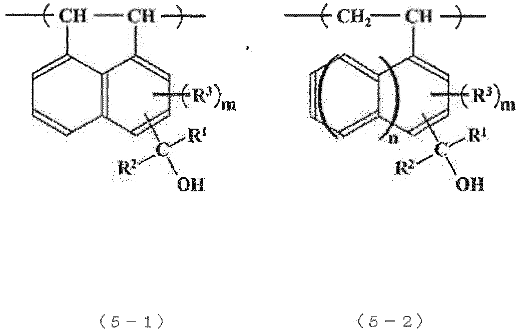

In the above formulae, R¹ and R² each represent a hydrogen atom, an alkyl group having 1 to 3 carbon atoms, or an aryl group; R³ represents an alkyl group having 1 to 3 carbon atoms, a vinyl group, an allyl group, or an optionally substituted aryl group; "n" represents 0 or 1; and "m" represents 0, 1, or 2.

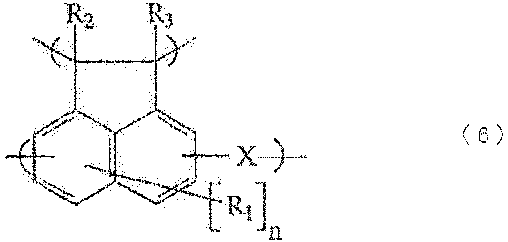

In the formula, R¹ represents a monovalent atom or group other than a hydrogen atom; "n" represents an integer of 0 to 4, given that when "n" is 2 to 4, these R¹'s may be the same or different; R² and R³ each independently represent a monovalent atom or group; and X represents a divalent group.

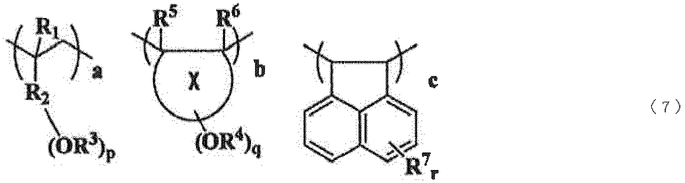

In the general formula (7), R¹ represents a hydrogen atom or a methyl group; R² represents any of a single bond, a linear, branched, or cyclic alkylene group having 1 to 20 carbon atoms, and an arylene group having 6 to 10 carbon atoms, and optionally has any of ether, ester, lactone, and amide; R³ and R⁴ each represent a hydrogen atom or a glycidyl group; X represents a polymer of any of an indene skeleton-containing hydrocarbon, a cycloolefin having 3 to 10 carbon atoms, and maleimide, and optionally has any of ether, ester, lactone, and carboxylic acid anhydride; R⁵ and R⁶ each represent any of a hydrogen atom, a fluorine atom, a methyl group, and a trifluoromethyl group; R⁷ represents any of a hydrogen atom, a linear, branched, or cyclic alkyl group having 1 to 6 carbon atoms, a hydroxy group, and an alkoxycarbonyl group; "p" and "q" each represent an integer of 1 to 4; "r" represents an integer of 0 to 4; and "a", "b", and "c" satisfy ranges of 0.5≤a+b+c≤1, 0≤a≤0.8, 0≤b≤0.8, 0.1≤a+b≤0.8, and 0.1≤c≤0.8.

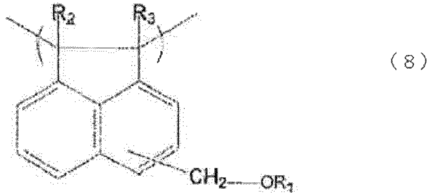

In the formula (8), R¹ represents a hydrogen atom or a monovalent organic group; R² and R³ each independently represent a monovalent atom or a monovalent organic group.

Examples of the naphthol compound include resins as follows, which are described in Japanese Unexamined Patent Application Publication Nos. 2004-205685, 2007-171895, 2009-14816, and so forth.

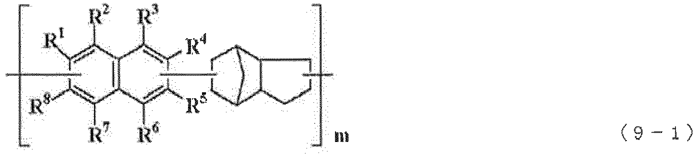

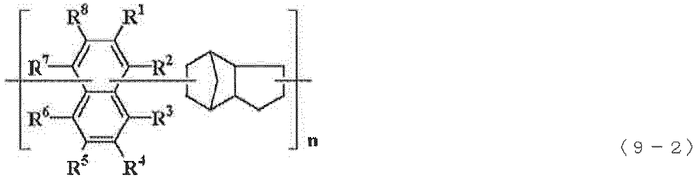

In the formulae, R¹ to R⁸ each independently represent a hydrogen atom, a hydroxyl group, an optionally substituted alkyl group having 1 to 6 carbon atoms, an optionally substituted alkoxy group having 1 to 6 carbon atoms, an optionally substituted alkoxycarboxyl group having 2 to 6 carbon atoms, an optionally substituted aryl group having 6 to 10 carbon atoms, a hydroxyalkyl group having 1 to 6 carbon atoms, an isocyanate group, or a glycidyl group; and "m" and "n" each represent a positive integer.

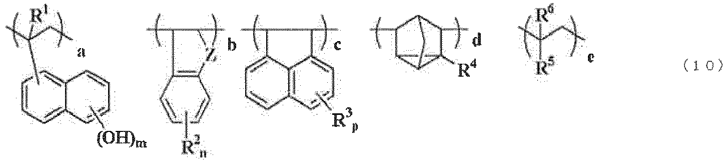

In the general formula (10), R¹ and R⁶ each represent a hydrogen atom or a methyl group; R², R³, and R⁴ each represent a hydrogen atom, an alkyl group having 1 to 4 carbon atoms, an alkoxy group, a hydroxy group, an acetoxy group, an alkoxycarbonyl group, or an aryl group having 6 to 10 carbon atoms; R⁵ represents a condensed polycyclic hydrocarbon group having 13 to 30 carbon atoms, -O-R⁷, -C(=O)-O-R⁷, -O-C(=O)-R⁷, or -C(=O)-NR⁸-R⁷; "m" represents 1 or 2; "n" represents an integer of 0 to 4; "p" represents an integer of 0 to 6; R⁷ represents an organic group having 7 to 30 carbon atoms; R⁸ represents a hydrogen atom or a hydrocarbon group having 1 to 6 carbon atoms; "a", "b", "c", "d", and "e" satisfy ranges of 0<a<1.0, 0≤b≤0.8, 0≤c≤0.8, 0≤d≤0.8, 0≤e≤0.8, and 0<b+c+d+e<1.0.

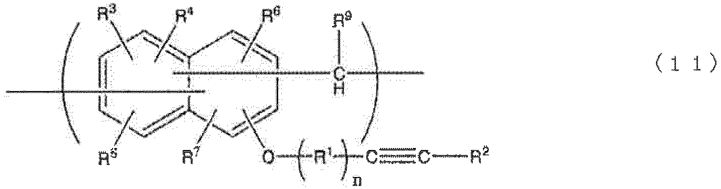

In the general formula (11), "n" represents 0 or 1; R¹ represents an optionally substituted methylene group, an optionally substituted alkylene group having 2 to 20 carbon atoms, or an optionally substituted arylene group having 6 to 20 carbon atoms; R² represents a hydrogen atom, an optionally substituted alkyl group having 1 to 20 carbon atoms, or an optionally substituted aryl group having 6 to 20 carbon atoms; R³ to R⁷ each represent a hydroxyl group, an optionally substituted alkyl group having 1 to 6 carbon atoms, an optionally substituted alkoxy group having 1 to 6 carbon atoms, an optionally substituted alkoxycarbonyl group having 2 to 10 carbon atoms, an optionally substituted aryl group having 6 to 14 carbon atoms, or an optionally substituted glycidyl ether group having 2 to 6 carbon atoms; R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms.

Besides, the examples of the organic underlayer film include resins and compositions described in WO2007-105776, WO2009-72465, WO2010-61774, WO2010-147155, WO2011-125839, WO2012-50064, WO2012-77640, WO2013-5797, WO2013-47106, WO2013-47516, WO2013-80929, WO2013-115097, WO2013-146670, WO2014-24836, WO2014-208324, WO2014-208499, WO2015-170736, WO2015-194273, WO2016-147989, Japanese Unexamined Patent Application Publication Nos. 2001-40293, 2002-214777, 2002-296789, 2005-128509, 2006-259249, 2006-285046, 2008-65081, 2009-229666, 2009-251130, 2010-15112, 2010-271654, 2011-107684, 2011-170059, 2012-1687, 2012-77295, 2012-214720, 2012-215842, 2013-83939, 2014-24831, 2014-157169, 2015-131954, 2015-183046, 2016-29160, 2016-44272, 2016-60886, 2016-145849, 2016-167047, 2016-216367, 2017-3959, 2017-119670, 2017-119671, 2013-516643, 2015-515112, and so forth.

### <Silicon-containing middle layer film>

The silicon-containing middle layer film (silicon-containing, coating-type middle layer film) used in the inventive patterning process is not particularly limited. Many silicon-containing middle layer films usable herein are known. In the present invention, in the case where the organic underlayer film pattern has the silicon-containing middle layer film remaining on the organic underlayer film, the dry-etched silicon-containing film residue and the organic underlayer film need to be simultaneously removed by washing with a stripping liquid. For this reason, the silicon content in the silicon-containing middle layer film is preferably 40 weight% or less, more preferably 35 weight% or less, and particularly preferably 30 weight% or less.

The silicon-containing middle layer film is formed from a composition for forming a silicon middle layer (the silicon-containing middle layer film), the composition containing a compound having a crosslinking organic structure.

Such a composition makes the resulting silicon-containing middle layer film more surely removable simultaneously with the organic underlayer film by the washing with the stripping liquid after the dry etching.

In this event, the crosslinking organic structure preferably include one or more selected from an oxirane ring, an oxetane ring, a hydroxyl group, or a carboxyl group.

Such a crosslinking organic structure makes the silicon-containing middle layer film further surely removable simultaneously with the organic underlayer film by the washing with the stripping liquid after the dry etching.

Moreover, the composition for forming a silicon middle layer preferably further contains an acid generator which generates an acid by one or both of heat and light.

Additionally, the composition for forming a silicon middle layer preferably further contains a crosslinking agent.

Such a composition(s) for forming a silicon middle layer promote crosslinking of the oxirane ring, oxetane ring, hydroxyl group, carboxyl group, or the like incorporated in the crosslinking organic structure. Furthermore, the composition makes it possible to form the silicon-containing middle layer film that is surely removable by the washing simultaneously with the organic underlayer film even after the dry etching.

The compositions for forming a silicon middle layer as described above and resins used in the compositions are not particularly limited. Examples thereof include compositions and resins described in Japanese Unexamined Patent Application Publication Nos. 2004-310019, 2005-15779, 2005-18054, 2005-352104, 2007-226170, and so forth.

Specific examples of the resins contained in the compositions for forming a silicon middle layer used in the present invention include polysiloxanes containing one or more of a compound shown by the following general formula (A-1), a hydrolysate, a condensate, and a hydrolysis condensate thereof.

R^{1A}_{A1}R^{2A}_{A2}R^{3A}_{A3}Si (OR^{OA}) _{(4-A1-A2-A3)} (A-1)

In the formula, R^{0A} represents a hydrocarbon group having 1 to 6 carbon atoms; R^{1A}, R^{2A}, and R^{3A} each represent a hydrogen atom or a monovalent organic group; and A1, A2, A3 each represent 0 or 1 while satisfying 0≤A1+A2+A3≤3.

Other examples of the organic group represented by R^{1A}, R^{2A}, and R^{3A} include organic groups having at least one carbon-oxygen single bond or carbon-oxygen double bond. Specific examples thereof include organic groups having one or more moieties selected from the group consisting of an oxirane ring, an oxetane ring, an ester bond, an alkoxy group, and a hydroxyl group. An example of such organic groups includes one shown by the following general formula (A-2).

(P-Q₁-(S₁)ᵥ₁-Q₂-)ᵤ-(T)ᵥ₂-Q₃-(S₂)ᵥ₃-Q₄- (A-2)

In the general formula (A-2), P represents a hydrogen atom, an oxirane ring, an oxetane ring, a hydroxyl group, an alkoxy group having 1 to 4 carbon atoms, an alkylcarbonyloxy group having 1 to 6 carbon atoms, or an alkylcarbonyl group having 1 to 6 carbon atoms; Q₁, Q₂, Q₃, and Q₄ each independently represent -C_{q}H_{(2q-p)}Pₚ-, where P is as defined above, "p" represents an integer of 0 to 3, and "q" represents an integer of 0 to 10, given that q=0 means a single bond; "u" represents an integer of 0 to 3; S₁ and S₂ each independently represent -O-, -CO-, -OCO-, -COO-, or -OCOO-; v1, v2, and v3 each independently represent 0 or 1. In addition to these, T represents a divalent group of an alicyclic or aromatic ring optionally containing a hetero atom, an oxirane ring, and an oxetane ring. Examples of the alicyclic or aromatic ring of T optionally containing a hetero atom such as an oxygen atom will be shown later. In T, positions where T bonds to Q₂ and Q₃ are not particularly limited, and can be appropriately selected by considering reactivity attributable to a steric factor, availability of a commercial reagent used in the reaction, and so on.

### <Upper layer resist film>

The upper layer resist film usable in the inventive patterning process is not particularly limited, and any of various conventionally known resist films is usable.

### <Water-repellent coating film>

Further, when the upper layer resist pattern is formed, if the upper layer resist needs a top coat to employ immersion exposure, a water-repellent coating film may be further formed on the upper layer resist film. The water-repellent coating film is not particularly limited, and various water-repellent coating films are usable.

### [Step (2)]

The step (2) is a step of subjecting the upper layer resist film to exposure and development to form an upper layer resist pattern.

In the step (2), the upper layer resist film is subjected to pattern exposure according to a conventional method by adopting a light source based on this resist film, for example, a KrF excimer laser beam or ArF excimer laser beam. Further, the upper layer resist film is subjected to a heat treatment under conditions based on the individual resist films. Then, a development operation with a developer is performed, and the resist pattern can be obtained.

### [Step (3)]

The step (3) is a step of transferring the upper layer resist pattern to the silicon-containing middle layer film by dry etching using the upper layer resist film having the formed upper layer resist pattern as a mask, and further transferring the upper layer resist pattern to the organic underlayer film by dry etching using the silicon-containing middle layer film having the transferred upper layer resist pattern as a mask to form an organic underlayer film pattern.

In the step (3), when the silicon-containing middle layer film is etched using the upper layer resist pattern as an etching mask under a dry etching condition where the etching speed of the silicon-containing middle layer film is significantly high relative to the organic underlayer film, for example, when dry etching is performed with fluorine-based gas plasma, this enables the silicon-containing middle layer film to have the upper layer resist pattern with little influence from the pattern change due to side etching of the resist film.

Next, the organic underlayer film is etched under a dry etching condition where the etching speed of the organic underlayer film is significantly high relative to the substrate having the silicon-containing middle layer film with the transferred upper layer resist pattern, for example, reactive dry etching is performed with gas plasma containing oxygen or with gas plasma containing hydrogen and nitrogen.

The organic underlayer film pattern is obtained by this etching step. Nevertheless, although the resist layer located uppermost is normally lost simultaneously with this step, a portion of the silicon-containing middle layer film served as the etching mask may be left on the upper portion of the organic underlayer film pattern as described below.

In the step (3), the organic underlayer film pattern may have the silicon-containing middle layer film remaining on the organic underlayer film.

Alternatively, in the step (3), the organic underlayer film pattern may not have the silicon-containing middle layer film remaining on the organic underlayer film.

In the inventive patterning process, even when the material having served as the mask remains or does not remain after the pattern is transferred by the dry etching, the inorganic silicon film pattern (sidewall pattern) can be formed without damaging the sidewalls and the substrate.

Note that when a pattern is transferred through multiple resist layers by dry etching which is actually employed in the process of manufacturing a semiconductor device, the rectangular shape of the pattern after the dry etching is ensured by setting such a condition that a portion of a patterned material serving as a mask is left on an upper portion of the transferred pattern in many cases. Specifically, in the inventive patterning process also, when the pattern is transferred to the silicon-containing middle layer film by dry etching using the upper layer resist as a mask, the step can be advanced under such a condition that a portion of the upper layer resist is left in order to ensure the rectangular shape of the cross section of the pattern of the silicon-containing middle layer film. Next, when the pattern is transferred to the organic underlayer film using the silicon-containing middle layer film as a mask also, the pattern transferring step can be advanced similarly in such a state that a portion of the silicon-containing middle layer film is left on the upper portion of the organic underlayer film to ensure the rectangular shape of the cross section of the pattern of the organic underlayer film. Then, the resulting organic underlayer film pattern is used as a core material in a sidewall spacer method, that is, after sidewalls are formed using the inorganic silicon film, the organic underlayer film pattern is removed to form the inorganic silicon film pattern. However, when the residue of the silicon-containing middle layer film remaining on the upper portion of the organic underlayer film pattern is to be removed by dry etching, the sidewalls formed of the inorganic silicon film and the substrate are damaged by the dry etching, resulting in the problems of poor product performance and yield decrease. Accordingly, in the inventive patterning process, wet processing is performed using a stripping liquid, as will be described later, to remove the silicon-containing middle layer film, so that such problems can be prevented.

### [Step (4)]

The step (4) is a step of forming an inorganic silicon film by a CVD method or an ALD method so as to cover the organic underlayer film pattern.

In this event, the inorganic silicon film is not particularly limited. Preferable examples thereof include polysilicon, amorphous silicon, silicon oxide, silicon nitride, silicon oxynitride, silicon carbide, and composite materials thereof.

### [Step (5)]

The step (5) is a step of removing a portion of the inorganic silicon film by dry etching to expose an upper portion of the organic underlayer film pattern.

The dry etching conditions in this event are not particularly limited. Depending on the composition of the inorganic silicon film, the gas condition and so forth can be determined.

### [Step (6)]

The step (6) is a step of removing the organic underlayer film pattern with a stripping liquid to form an inorganic silicon film pattern whose pattern pitch is 1/2 of that of the upper layer resist pattern.

Additionally, in the step (6), the stripping liquid preferably contains one or both of hydrogen peroxide and sulfuric acid.

For example, Japanese Unexamined Patent Application Publication No. 2009-212163 has proposed a method in which a core material is removed by wet processing. To be more specific, paragraph [0010] of this gazette discloses that when an underlayer film mainly made of carbon is used as a core material, an inorganic film is preferably formed between the upper layer resist and the underlayer film in order to ensure the dry etching selectivity. On the other hand, paragraph [0019] of the gazette discloses that when the core material is removed, if its main component is carbon, a treatment with sulfuric acid and hydrogen peroxide solution (SH treatment) can be performed. However, in an actual process, the inorganic film is left on the upper portion of the underlayer film to keep the rectangular shape of the core material after dry etching. When this inorganic film is removed by the wet process, the inorganic film residue is removed with hydrofluoric acid, hot phosphoric acid, or the like, and then the remaining carbon content is removed by the SH treatment. This removal step is cumbersome and uneconomical. In addition, the combination that can ensure the selectivity of dry etching processing and the selectivity of wet processing among the substrate, the sidewall spacer, the core material, and the inorganic film below the upper layer resist is very complicated and can be a major obstacle to constructing a process for manufacturing a semiconductor device.

In the step (6) in the present invention, the organic underlayer film pattern can be removed simultaneously with the silicon-containing film residue, if remaining thereon, by using a stripping liquid. For the wet stripping of the organic underlayer film pattern, it is more preferable to use the stripping liquid containing hydrogen peroxide. In this event, an acid or an alkali is further preferably added to adjust the pH to promote the stripping. Examples of the pH adjuster include inorganic acids such as hydrochloric acid and sulfuric acid; organic acids such as acetic acid, oxalic acid, tartaric acid, citric acid, and lactic acid; nitrogen-containing alkalis such as ammonia, ethanolamine, and tetramethylammonium hydroxide; nitrogen-containing organic acid compounds such as EDTA (ethylenediamine tetraacetic acid); and the like.

The stripping liquid is normally an aqueous solution, but may contain an organic solvent in some cases. This organic solvent includes water-soluble alcohols, ethers, ketones, esters, amides, imides, and the like. Specific examples thereof includes methanol, ethanol, propanol, butanol, ethylene glycol, propylene glycol, diethylene glycol, dipropylene glycol, ethylene glycol methyl ether, ethylene glycol dimethyl ether, ethylene glycol ethyl ether, ethylene glycol diethyl ether, diethylene glycol methyl ether, diethylene glycol dimethyl ether, diethylene glycol ethyl ether, diethylene glycol diethyl ether, propylene glycol methyl ether, propylene glycol dimethyl ether, propylene glycol ethyl ether, propylene glycol diethyl ether, dipropylene glycol methyl ether, dipropylene glycol dimethyl ether, dipropylene glycol ethyl ether, dipropylene glycol diethyl ether, tetrahydrofuran, tetrahydrofurfuryl alcohol, acetone, methyl ethyl ketone, ethyl lactate, N-methylpyrrolidinone, N,N-dimethyl formamide, N,N-dimethylacetamide, and the like.

The wet stripping can be performed only by: preparing a stripping liquid at 0°C to 200°C, preferably 20°C to 180°C; and immersing therein a silicon wafer having a target substrate to be processed. Furthermore, if necessary, the organic film pattern can be readily removed according to a conventional procedure such as spraying the stripping liquid onto the surface, or applying the stripping liquid thereto while the wafer is being rotated.

### EXAMPLE

Hereinafter, the present invention will be specifically described with reference to Examples and Comparative Example. However, the present invention is limited to the scope of the claims, only.

### <Example 1>

As the organic underlayer film on the substrate, ODL-306 manufactured by Shin-Etsu Chemical Co., Ltd. was used and applied onto a Si wafer by spin-coating. After baking at 350°C for 60 seconds, a carbon film having a thickness of 80 nm was prepared. The carbon proportion of the carbon film was 88%. The silicon-containing middle layer film was prepared on the carbon film using a composition including the following raw materials. Specifically, the composition was applied onto the organic underlayer film by spin-coating and baked at 200°C for 60 seconds to prepare the silicon-containing middle layer film having a thickness of 30 nm.

### Silicon-containing polymer (1)

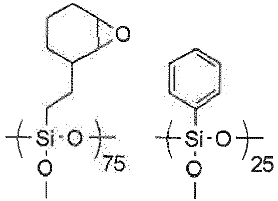

### Acid generator

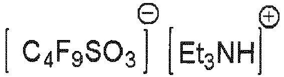

### Organic solvent: PGMEA (propylene glycol monomethyl ether acetate)

Further, an upper layer resist film having the following composition was applied onto the silicon-containing middle layer film by spin-coating, and baked at 110°C for 60 seconds. Thereby, the resist film had a thickness of 120 nm.

### Polymer 1

Molecular weight (Mw)=8,100
Dispersity (Mw/Mn)=1.77

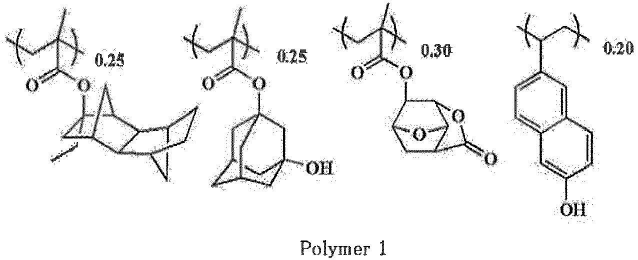

### Acid generator: PAG1

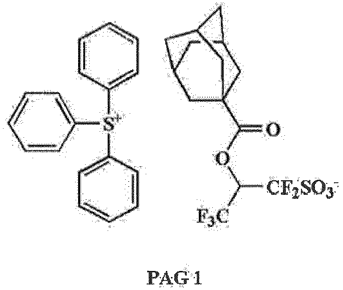

### Basic compound: Quencher 1

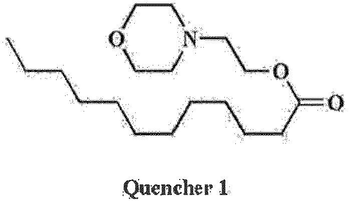

### Organic solvents: PGMEA (propylene glycol monomethyl ether acetate), and CyH (cyclohexanone)

The resultant was subjected to exposure using an ArF excimer laser scanner (NSR-S307E manufactured by Nikon Corporation, NA: 0.85, σ: 0.93/0.69, 20° dipole illumination, 6% halftone phase shift mask). Immediately after the photo-exposure, the resultant was baked at 100°C for 60 seconds and subjected to development with a 2.38 mass% tetramethylammonium hydroxide aqueous solution for 30 seconds. Thus, a positive isolated pattern (resist pattern) with a dimension of 50 nm and a pitch of 130 nm was obtained.

Using the resist pattern as a mask, the silicon-containing middle layer film was processed by dry etching under the following conditions (1). Then, the pattern was transferred to the organic underlayer film under the following conditions (2).

### (1) Etching conditions with CHF₃/CF₄-based gas

### Apparatus: dry etching apparatus Telius SP manufactured by Tokyo Electron Limited

### Etching conditions (1):

| | |
|---|---|
| Chamber pressure | 10 Pa |
| Upper/Lower RF power | 500 W/300 W |
| CHF₃ gas flow rate | 50 ml/min |
| CF₄ gas flow rate | 150 ml/min |
| Ar gas flow rate | 100 ml/min |
| Treatment time | 40 sec |

### (2) Etching conditions with O₂/N₂-based gas

### Apparatus: dry etching apparatus Telius SP manufactured by Tokyo Electron Limited

### Etching conditions (2):

| | |
|---|---|
| Chamber pressure | 2 Pa |
| Upper/Lower RF power | 1000 W/300 W |
| O₂ gas flow rate | 300 ml/min |
| N₂ gas flow rate | 100 ml/min |
| Ar gas flow rate | 100 ml/min |
| Treatment time | 30 sec |

On the obtained organic underlayer film pattern, a silicon oxide film (ALD film) with a thickness of 30 nm was formed according to the method described from [0043] to [0053] in Example of Japanese Unexamined Patent Application Publication No. 2005-197561 using an ALD apparatus. Subsequently, to expose an upper portion of the organic underlayer film pattern, the ALD film was dry-etched under the following conditions (3). Thereby, a test wafer A was obtained from which the core material was exposed.

### (3) Etching conditions with CHF₃/CF₄-based gas

### Apparatus: dry etching apparatus Telius SP manufactured by Tokyo Electron Limited

### Etching conditions (3):

| | |
|---|---|
| Chamber pressure | 10 Pa |
| Upper/Lower RF power | 200 W/100 W |
| CHF₃ gas flow rate | 50 ml/min |
| CF₄ gas flow rate | 50 ml/min |
| Ar gas flow rate | 100 ml/min |
| Treatment time | 20 sec |

The obtained test wafer A was treated with a sulfuric acid-hydrogen peroxide solution (H₂SO₄/H₂O_{2/}H₂O=96/1/3), and then the cross-sectional shape was observed with S-4700 manufactured by Hitachi High-Technologies Corporation. The result verified that the sidewall pattern and the substrate were not damaged when the core material was removed.

### <Example 2>

Similarly, the above-described treatments were performed, except that the silicon-containing middle layer film was prepared using a composition including the following raw materials. No damage to the sidewall pattern and the substrate was verified.

### Silicon-containing polymer (2)

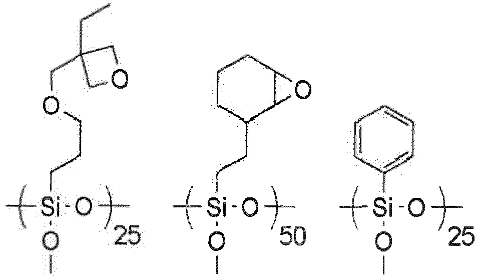

### Acid generator

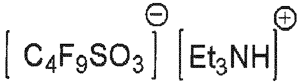

### Organic solvent: PGMEA (propylene glycol monomethyl ether acetate)

### <Comparative Example>

The test wafer A obtained in Example 1 was treated under the following dry etching conditions to remove the core material. The result verified that the sidewall pattern and the substrate were damaged when the core pattern was removed.

### (4) Etching conditions with O₂/N₂-based gas

### Apparatus: dry etching apparatus Telius SP manufactured by Tokyo Electron Limited

### Etching conditions (4):

| | |
|---|---|
| Chamber pressure | 5 Pa |
| Upper/Lower RF power | 1000 W/300 W |
| O₂ gas flow rate | 300 ml/min |
| N₂ gas flow rate | 100 ml/min |
| Ar gas flow rate | 100 ml/min |
| Treatment time | 30 sec |

From the above results, in Examples employing the inventive patterning process, the sidewall patterns and the substrates were not damaged by removing the core patterns. This revealed that the inventive patterning process is capable of solving the problems of poor product performance and yield decrease. Meanwhile, in Comparative Example, not the wet processing but the dry etching was employed when the core pattern was removed. Consequently, the sidewall pattern and the substrate were damaged.

It should be noted that the present invention is not limited to the above-described embodiments. The embodiments are just examples, and any examples that are encompassed by the scope of the claims are part of the present invention.

## Claims

1. A patterning process comprising the steps of:
(1) forming on a substrate an organic underlayer film, a silicon-containing middle layer film thereon, and further an upper layer resist film thereon;
(2) subjecting the upper layer resist film to exposure and development to form an upper layer resist pattern;
(3) transferring the upper layer resist pattern to the silicon-containing middle layer film by dry etching using the upper layer resist film having the formed upper layer resist pattern as a mask, and further transferring the upper layer resist pattern to the organic underlayer film by dry etching using the silicon-containing middle layer film having the transferred upper layer resist pattern as a mask to form an organic underlayer film pattern;
(4) forming an inorganic silicon film by a CVD method or an ALD method so as to cover the organic underlayer film pattern;
(5) removing a portion of the inorganic silicon film by dry etching to expose an upper portion of the organic underlayer film pattern; and
(6) removing the organic underlayer film pattern with a stripping liquid to form an inorganic silicon film pattern whose pattern pitch is 1/2 of that of the upper layer resist pattern,
**characterized in that**
the silicon-containing middle layer film is formed from a composition for forming a silicon middle layer, the composition containing a compound having a crosslinking organic structure,
the organic underlayer film contains any of a fluorene skeleton-containing compound, a carbazole skeleton-containing compound, an acenaphthylene skeleton-containing compound, a naphthol skeleton-containing compound, and a bisnaphthol skeleton-containing compound, and
the inorganic silicon film is made of polysilicon, amorphous silicon, silicon oxide, silicon oxynitride, silicon carbide, or a composite material thereof.

2. The patterning process according to claim 1 wherein, in the step (1), a water-repellent coating film is further formed on the upper layer resist film.

3. The patterning process according to claim 1 or 2, wherein, in the step (3), the organic underlayer film pattern has the silicon-containing middle layer film remaining on the organic underlayer film.

4. The patterning process according to claim 1 or 2, wherein, in the step (3), the organic underlayer film pattern does not have the silicon-containing middle layer film remaining on the organic underlayer film.

5. The patterning process according to any one of claims 1 to 4, wherein, in the step (6), the stripping liquid contains one or both of hydrogen peroxide and sulfuric acid.

6. The patterning process according to claim 1, wherein the crosslinking organic structure is one or more selected from an oxirane ring, an oxetane ring, a hydroxyl group, or a carboxyl group.

7. The patterning process according to any one of the preceding claims, wherein the composition for forming a silicon middle layer further contains an acid generator which generates an acid by one or both of heat and light.

## Patentansprüche

1. Strukturierungsverfahren, umfassend die folgenden Schritte:
(1) Ausbilden eines organischen Unterschichtfilms auf einem Substrat, eines siliziumhaltigen Mittelschichtfilms darauf und eines oberen Widerstandsfilms darauf;
(2) Belichten und Entwickeln des oberen Widerstandsfilms, um ein oberen Schichtwiderstandsmuster zu bilden;
(3) Übertragen des oberen Schichtwiderstandsmusters auf den siliziumhaltigen Mittelschichtfilm durch Trockenätzen unter Verwendung des oberen Widerstandsfilms, der das gebildete obere Schichtwiderstandsmuster als Maske aufweist, und weiteres Übertragen des oberen Schichtwiderstandsmusters auf den organischen Unterschichtfilm durch Trockenätzen unter Verwendung des siliziumhaltigen Mittelschichtfilms, der das übertragene obere Schichtwiderstandsmuster als Maske aufweist, um ein organisches Unterschichtfilmmuster zu bilden;
(4) Ausbilden eines anorganischen Siliziumfilms durch ein CVD-Verfahren oder ein ALD-Verfahren, um das Muster des organischen Unterschichtfilms zu bedecken;
(5) Entfernen eines Teils des anorganischen Siliziumfilms durch Trockenätzen, um einen oberen Teil des organischen Unterschichtfilmmusters freizulegen; und
(6) Entfernen des organischen Unterschichtfilmmusters mit einer Abziehflüssigkeit, um ein anorganisches Siliziumfilmmuster zu bilden, dessen Musterabstand 1/2 desjenigen des oberen Schichtwiderstandsmusters beträgt,
**dadurch gekennzeichnet, dass**
der siliziumhaltige Mittelschichtfilm aus einer Zusammensetzung zur Bildung einer Siliziummittelschicht gebildet wird, wobei die Zusammensetzung eine Verbindung mit einer vernetzenden organischen Struktur enthält,
der organische Unterschichtfilm eine beliebige Fluorengerüst-haltige Verbindung, eine Carbazolgerüst-haltige Verbindung, eine Acenaphthylengerüsthaltige Verbindung, eine Naphtholgerüst-haltige Verbindung und eine Bisnaphtholgerüst-haltige Verbindung enthält, und
die anorganische Siliziumschicht aus Polysilizium, amorphem Silizium, Siliziumoxid, Siliziumoxynitrid, Siliziumkarbid oder einem Verbundmaterial daraus besteht.

2. Strukturierungsverfahren nach Anspruch 1, wobei in Schritt (1) ferner ein wasserabweisender Beschichtungsfilm auf dem oberen Schichtwiderstandsfilm gebildet wird.

3. Strukturierungsverfahren nach Anspruch 1 oder 2, wobei in Schritt (3) das Muster des organischen Unterschichtfilms den siliziumhaltigen Mittelschichtfilm aufweist, der auf dem organischen Unterschichtfilm verbleibt.

4. Strukturierungsverfahren nach Anspruch 1 oder 2, wobei in Schritt (3) das Muster des organischen Unterschichtfilms nicht den siliziumhaltigen Mittelschichtfilm aufweist, der auf dem organischen Unterschichtfilm verbleibt.

5. Strukturierungsverfahren nach einem der Ansprüche 1 bis 4, wobei in Schritt (6) die Abziehflüssigkeit Wasserstoffperoxid oder Schwefelsäure oder beides enthält.

6. Strukturierungsverfahren nach Anspruch 1, wobei die vernetzende organische Struktur eine oder mehrere aus einem Oxiranring, einem Oxetanring, einer Hydroxylgruppe oder einer Carboxylgruppe ausgewählte ist.

7. Strukturierungsverfahren nach einem der vorhergehenden Ansprüche, wobei die Zusammensetzung zur Bildung einer Silizium-Mittelschicht ferner einen Säuregenerator enthält, der eine Säure durch Wärme oder Licht oder beides erzeugt.

## Revendications

1. Procédé de formation de motifs comprenant les étapes consistant à:
(1) former un film organique de sous-couche sur un substrat, sur lequel est formé un film de couche intermédiaire contenant du silicium et un film de résistance de couche supérieure;
(2) soumettre le film de réserve de couche supérieure à une exposition et à un développement pour former un motif de réserve de couche supérieure;
(3) transférer le motif de réserve de couche supérieure au film de la couche intermédiaire contenant du silicium par gravure à sec en faisant appel au film de réserve de couche supérieure ayant le motif de réserve de couche supérieure formé comme masque, et transférer en outre le motif de réserve de couche supérieure au film de sous-couche organique par gravure à sec en faisant appel au film de couche intermédiaire contenant du silicium ayant le motif de réserve de couche supérieure transféré comme masque pour former un motif de film de sous-couche organique;
(4) former un film de silicium inorganique selon une méthode CVD ou une méthode ALD de manière à recouvrir le motif du film de sous-couche organique;
(5) enlever une partie du film de silicium inorganique par gravure à sec pour rendre apparente une partie supérieure du motif du film de sous-couche organique; et
(6) enlever le motif du film de sous-couche organique à l'aide d'un liquide de décapage pour former un motif de film de silicium inorganique dont le pas de motif est égal à 1/2 de celui du motif de réserve de couche supérieure,
**caractérisé en ce que**
le film de couche intermédiaire contenant du silicium est formé à partir d'une composition destinée à former une couche intermédiaire en silicium, la composition contenant un composé ayant une structure organique réticulée,
le film de sous-couche organique contient un quelconque parmi un composé contenant un squelette de fluorène, un composé contenant un squelette de carbazole, un composé contenant un squelette d'acénaphthylène, un composé contenant un squelette de naphtol et un composé contenant un squelette de bisnaphtol, et
le film de silicium inorganique est constitué de polysilicium, de silicium amorphe, d'oxyde de silicium, d'oxynitrure de silicium, de carbure de silicium ou d'un de leurs matériaux composites.

2. Procédé de formation de motifs selon la revendication 1, dans lequel à l'étape (1), un film de revêtement hydrofuge est formé sur le film de réserve de couche supérieure.

3. Procédé de formation de motifs selon la revendication 1 ou 2, dans lequel à l'étape (3), le motif de film de sous-couche organique comporte le film de couche intermédiaire contenant du silicium qui reste sur le film de sous-couche organique.

4. Procédé de formation de motifs selon la revendication 1 ou 2, dans lequel, à l'étape (3), le motif de film de sous-couche organique ne comporte pas de film de couche intermédiaire contenant du silicium restant sur le film de sous-couche organique.

5. Procédé de formation de motifs selon l'une quelconque des revendications 1 à 4, dans lequel à l'étape (6), le liquide de décapage contient du peroxyde d'hydrogène et de l'acide sulfurique ou les deux.

6. Procédé de formation de motifs selon la revendication 1, dans lequel la structure organique réticulée est une ou plusieurs choisies parmi un cycle oxirane, un cycle oxétane, un groupe hydroxyle ou un groupe carboxyle.

7. Procédé de formation de motifs selon l'une quelconque des revendications précédentes, dans lequel la composition destinée à former une couche intermédiaire de silicium contient en outre un générateur d'acide qui produit un acide par la chaleur ou la lumière, ou les deux.
